# EUROPÄISCHE PATENTSCHRIFT

(11) **EP 1 043 736 B1**
(45) Veröffentlichungstag und Bekanntmachung des Hinweises auf die Patenterteilung: **31.05.2006**
(21) Anmeldenummer: 00106116.7
(22) Anmeldetag: 21.03.2000
(51) Int. Cl.: H01F 19/04, H01F 17/06, H01P 5/10, H03H 7/42

(54) **Transformatoranordnung für einen Gegentakt-Verstärker eines Kurz- oder Ultrakurzwellen-Senders**
Transformer assembly for push-pull amplifier of short or ultrashort wave transmitter
Dispositif transformateur pour amplificateur "push-pull" d'èmetteur à ondes courtes ou ultracourtes

(30) Priorität: 07.04.1999 DE 19915649
(43) Veröffentlichungstag der Anmeldung: 11.10.2000
(73) Patentinhaber: Rohde & Schwarz GmbH & Co. KG, 81671 München (DE)
(72) Erfinder: Becker, Jo, 81245 München (DE)
(74) Vertreter: Graf, Walter

(56) Entgegenhaltungen:
- EP-A- 0 836 203
- GB-A- 2 285 892
- US-A- 3 766 499
- US-A- 5 808 518
- PATENT ABSTRACTS OF JAPAN vol. 010, no. 283 (E-440), 26. September 1986 (1986-09-26) & JP 61 101109 A (MATSUSHITA ELECTRIC IND CO LTD), 20. Mai 1986 (1986-05-20)

## Beschreibung

Die Erfindung betrifft eine Transformatoranordnung laut Oberbegriff des Hauptanspruches.

Zur ein- und ausgangsseitigen Zusammenfassung von Transistor-Gegentakt-Leistungsverstärkern bei Kurzwellen- bzw. Ultrakurzwellen-Sendern sind Leistungs-ImpedanzTransformatoren erforderlich, die meist als sogenannte Leitungstransformatoren (Guanellaübertrager) ausgebildet sind. Je nach dem gewünschten Übersetzungsverhältnis des Impedanz-Transformators werden dabei zwei, drei oder mehrere Doppelleiter beispielsweise eingangsseitig parallel und ausgangsseitig in Serie geschaltet (oder umgekehrt), die ausgangsseitige (bzw. eingangsseitige) Verbindungsleitung zwischen diesen Doppelleiteranordnungen wird dabei meist hochfrequenzmäßig auf Nullpotential (Masse) gelegt. Nach diesem Prinzip kann beispielsweise mit zwei Doppelleitungen eine Impedanztransformation von 4:1 erreicht werden, noch höhere Übersetzungsverhältnisse mit drei oder mehreren in Serien-Parallel-Schaltung betriebenen Doppelleitungen (nach DAS 1 159 527). Es ist auch schon bekannt, solche Leitungstransformatoren in gedruckter Schaltungstechnik aufzubauen.

Bei den bisher üblichen Leitungstransformatoren dieser Art ist jeder Doppelleitung ein gesonderter Ferritkern zugeordnet, die Doppelleitungen sind gegenseitig nicht magnetisch verkoppelt (USP 5,808,518). Wenn neben einer Impedanztransformation auch noch eine Symmetrierung erforderlich ist, muß bei diesen bekannten Leitungstransformatoren noch ein zusätzlicher Symmetriertransformator vorgesehen werden (H. Granberg: LINEAR AMPLIFIERS FOR MOBILE OPERATION, MOTOROLA, AN762, 1976), so daß neben den meist relativ voluminösen dreidimensionalen Ringkerntransformatoren des Impedanztransformators (H. Granberg: BROADBAND TRANSFORMERS AND POWER COMBINING TECHNIQUES FOR RF, 1976, AN749 der Firma MOTOROLA, RF DEVICE DATA BOOK, Vol. 2, 1990, Seiten 7-98 bis 7-106) zusätzlich noch ein entsprechend voluminöser Symmetriertransformator erforderlich ist und hierdurch solche Gegentakt-Verstärkeranordnungen insgesamt sehr aufwendig und voluminös werden.

Es ist ferner ein Transformator dieser Art bekannt, bei dem die zu Doppelleiter zusammengefaßten Leiter durch einen gemeinsamen Ferritkern geführt und magnetisch miteinander verkoppelt sind (Abstract of Japan, Vol. 010, Nr. 283 (E-440), 26. September 1986 & JP 61 101109 A).

Ferner ist es bekannt, einen Transformator strukturell mit einer Leiterplatte zu kombinieren, auf welcher in gedruckter Schaltungstechnik eine elektronische Schaltung ausgebildet ist (GB 2 285 892). Der Transformatorkern ist dabei aus zwei E-förmigen Kernteilen zusammengesetzt, deren Vorsprünge in Ausnehmungen der gedruckten Schaltungsplatte eingesetzt sind. Die Transformatorwindungen sind auf zusätzlichen Leiterplatten, die oberhalb und unterhalb der die Schaltung tragenden Leiterplatte angeordnet sind, einseitig in gedruckter Schaltungstechnik ausgebildet.

Es ist Aufgabe der Erfindung, eine Transformatoranordnung für den Gegentaktverstärker eines Kurzwellen- oder Ultrakurzwellen-Senders zu schaffen, die einfach, preiswert und mit äußerst kleinen Abmessungen auch in Massenproduktion herstellbar ist und sich damit besonders zum Bau von leichten, tragbaren und mobilen KurzwellenSendern eignet.

Diese Aufgabe wird ausgehend von einer Transformatoranordnung laut Oberbegriff des Hauptanspruches durch dessen kennzeichnende Merkmale gelöst.

Eine erfindungsgemäß in gedruckter Schaltungstechnik aufgebaute Transformatoranordnung, bei der die Leiter als Leiterschleifen übereinander auf einer mehrlagigen Leiterplatte ausgebildet sind, ermöglicht einen sehr gedrungenen Gesamtaufbau mit äußerst kleinen Abmessungen. Sie kann auch sehr einfach und preiswert in Massenproduktion in gleichbleibend guter Reproduzierbarkeit hergestellt werden. Sie eignet sich damit besonders zum Bau von leichten, tragbaren und mobilen Kurzwellensendern. Durch die Doppelfunktion als Impedanztransformator bzw. Symmetrierübertrager und Einsparung eines zusätzlichen Symmetriertransformators wird damit erstmals der Aufbau von Kurzwellen-Senderendstufen möglich, die trotz einer Ausgangsleistung von beispielsweise 1kW sehr klein, mit geringem Gewicht und insgesamt sehr gedrungen aufgebaut sind. Je nach gewünschtem Übersetzungsverhältnis des Impedanztransformators können in bekannter Weise (DAS 1 159 527) zwei oder mehr Serien-Parallel-Schaltungen von Doppelleitungen nach dem Guanella-Prinzip angewendet werden, deren einzelne Leiter alle jeweils einem gemeinsamen Magnetfluß ausgesetzt sind.

Die Erfindung wird im Folgenden anhand schematischer Zeichnungen näher erläutert.

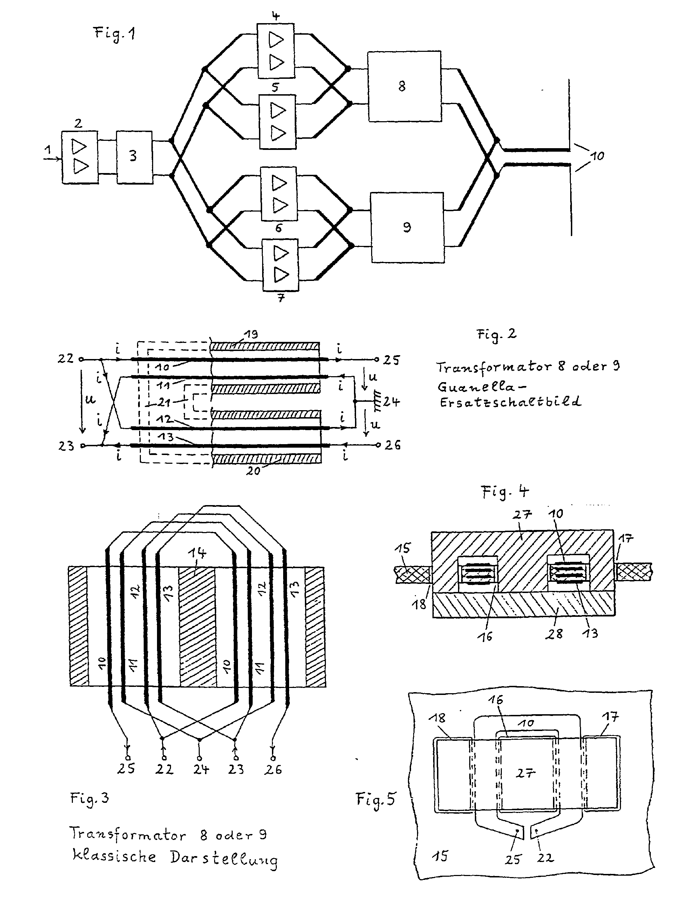

Figur 1 zeigt das Prinzipschaltbild einer bekannten Kurzwellen-Senderendstufe. Das am Eingang 1 zugeführte, in der Frequenz und Modulation aufbereitete Eingangssignal wird in einem als Transistor-Gegentakt-Verstärker ausgebildeten Vorverstärker 2 verstärkt und über einen Impedanztransformator 3 den als Transistor-Gegentakt-Leistungsverstärker ausgebildeten Endstufen 4 bis 7 zugeführt, deren Ausgänge wieder über Impedanztransformatoren 8 und 9 zusammengefaßt die Ausgangsleistung von beispielsweise 1kW an die Antenne 10 abgeben. Gemäß der Erfindung sind diese Impedanztransformatoren 3, 8 bzw. 9 nach dem sogenannten Guanella-Prinzip ausgebildet. Figur 2 zeigt das Ersatzschaltbild eines Guanella-Übertragers, der aus zwei miteinander verkoppelten Doppelleitern 10, 11 bzw. 12, 13 besteht, die in dem Beispiel eingangsseitig parallel und ausgangsseitig in Reihe geschaltet sind. Der ausgangsseitige Verbindungspunkt zwischen diesen beiden Doppelleitungen ist bei 24 an Masse gelegt. Entgegen der bekannten Anordnung eines Guanella-Übertragers sind die beiden Doppelleitungen 10, 11 und 12, 13 nicht getrennten Magnetflüssen ausgesetzt, sondern einem gemeinsamen Magnetfluß, wie dies durch die gestrichelt angedeutete Verbindung 21 der beiden Ferritkernteile 19 und 20, die den beiden Doppelleitungen 10, 11 bzw. 12, 13 zugeordnet sind, in Figur 2 schematisch angedeutet ist.

Figur 3 zeigt die gleiche Darstellung einer Transformatoranordnung in der klassischen Transformatoranordnung. In einem Doppelloch-Ferritkern 14 sind wieder die jeweils zu Doppelleitungen zusammengefaßten vier Leiter 10, 11, 12 und 13 parallel zueinander als Leiterschleifen geführt und über den Ferritkern 14 nach dem klassischen Transformatorprinzip magnetisch miteinander verkoppelt. Die Enden dieser Leiterschleifen 10 bis 13 sind gemäß Figur 3 nach dem Guanella-Prinzip miteinander verbunden, wie dies auch das Ersatzschaltbild nach Figur 2 zeigt, so daß die beiden Doppelleitungen 10, 11 und 12, 13 wieder eingangsseitig parallel und ausgangsseitig in Serie an Masse 24 liegen. Durch diese magnetische Verkopplung der Einzelleiter beider Doppelleitungen wirkt eine solche Transformatoranordnung nach dem Guanella-Prinzip als 4:1-Impedanztransformator, gleichzeitig über die klassische Transformatorfunktion jedoch auch als Symmetrierglied zur Symmetrierung der Eingänge 22, 23 gegen Masse 24.

Figuren 4 und 5 zeigen die erfindungsgemäße technische Realisierung einer solchen Transformatoranordnung nach den Figuren 2 und 3 in gedruckter Schaltungstechnik. In diesen Aus Führungsbeispiel sind die Leiter 10 bis 13 beispielsweise als Leiterschleifen übereinander auf den übereinanderliegenden Schichten einer Mehrlagenplatine 15 ausgebildet. Innerhalb dieser übereinanderliegenden Schleifen 10 bis 13 (in der Draufsicht nach Figur 5 ist nur die oberste Schleife 10 sichtbar) ist in der Platine 15 eine Ausnehmung 16 ausgebildet, außerhalb der Schleife zwei weitere Ausnehmungen 17 und 18. In diese Platinenausnehmungen 16, 17, 18 sind die Vorsprünge eines E-förmigen Ferritkernes 27 eingesetzt, auf der Unterseite der Platine ist auf die Enden der E-Kernvorsprünge eine den magnetischen Fluß schließende Ferritplatte 28 aufgesetzt.

Ein genereller Vorteil der in gedruckter Planartechnik ausgeführten Leistungstransformatoren ist ihre exakt reproduzierbare Geometrie, dies gestattet, wie Figur 1 zeigt, die direkte Parallelschaltung mehrerer MOSFET-Transistor-Paare ohne Gefahr von elektrischen Instabilitäten. Dadurch spart man die üblichen Leistungsteiler zwischen Vor- und Endverstärker sowie die Leistungskombinierer nach den Endstufen ein. Diese Baugruppen beanspruchen jeweils das gleiche Volumen wie ein leistungsgleicher Impedanztransformator. Ein Sender gemäß Figur 1 benötigt also nur 3 statt bisher 9 Hochfrequenz-Transformatoren vergleichbarer Größe. Die genannten Vorteile kommen besonders zum Tragen bei Sendern hoher Leistung (1kW) mit niedriger Betriebsspannung (28V). Die nutzbare Frequenzbandbreite ist mehr als doppelt so groß wie bei den bekannten Konstruktionen gleicher Leistung.

## Patentansprüche

1. Transformatoranordnung für einen Gegentakt-Verstärker einer Kurzwellen- oder Ultrakurzwellen-Senderendstufe, mit vier parallel zueinander angeordneten Leitern (10 - 13), die zu Doppelleiter zusammengefaßt durch einen gemeinsamen Ferritkern (27,28) geführt, magnetisch verkoppelt und eingangsseitig parallel und ausgangsseitig in Reihe geschaltet sind und deren ausgangsseitiger Verbindungspunkt (24) an Nullpotential liegt,
**dadurch gekennzeichnet,**
**daß** die Leiter (10 - 13) in gedruckter Schaltungstechnik als Leiterschleifen übereinander auf einer mehrlagigen Leiterplatte (15) ausgebildet sind und der Ferritkern (27,28) in Ausnehmungen (16,17,18) der Leiterplatte (15) eingesetzt ist und
**daß** der Ferritkern aus einem E-förmigen Kernteil (27) besteht, dessen Vorsprünge von der einen Seite der Leiterplatte (15) in die neben den Leiterschleifen ausgebildeten Ausnehmungen (16,17,18) eingesetzt sind, und auf die Enden dieser Vorsprünge dieses E-förmigen Kernteils (27) auf der anderen Seite der Leiterplatte (15) eine Ferritplatte (28) aufgesetzt ist.

## Claims

1. Transformer arrangement for a push-pull amplifier of a short-wave or ultra-short-wave transmitter output stage, with four conductors (10 - 13) arranged parallel to one another, which are combined to form double conductors, guided through a common ferrite core (27, 28), magnetically coupled and connected in parallel at the input end and in series at the output end, and of which the output-end connecting point (24) is disposed at zero potential,
**characterised in that**
the conductors (10 - 13) are designed using printed-circuit technology as conductor loops disposed one above the other on a multi-layer printed-circuit board (15); that the ferrite core (27, 28) is inserted in recesses (16, 17, 18) of the printed-circuit board (15); that the ferrite core consists of an E-shaped core component (27), of which the projections are inserted from one side of the printed-circuit board (15) into the recesses (16, 17, 18) formed alongside the conductor loops; and that a ferrite plate (28) is placed at the other side of the printed-circuit board (15) on the ends of the projections of this E-shaped core component (27).

## Revendications

1. Agencement de transformateur pour un amplificateur push-pull d'un étage final d'émetteur à ondes courtes ou ultracourtes, avec quatre conducteurs (10-13), disposés parallèlement les uns aux autres qui, réunis en conducteurs doubles, sont guidés à travers un noyau de ferrite commun (27, 28), sont couplés magnétiquement et sont montés côté entrée parallèlement et côté sortie en série et dont le point de connexion côté sortie (24) est mis à la masse,
**caractérisé**
**en ce que** les conducteurs (10-13) sont réalisés selon une technique de circuits imprimés comme boucles de conducteur les uns au-dessus des autres sur une plaquette de circuit imprimé multicouche (15), et le noyau de ferrite (27,28) est placé dans des évidements (16,17,18) de la plaquette à circuit imprimé (15) et
**en ce que** le noyau de ferrite est constitué d'une partie de noyau en forme de E (27), dont les saillies sont placées depuis un côté de la plaquette à circuit imprimé (15) dans les évidements (16,17,18) réalisés à côté des boucles de conducteur, et sur les extrémités de ces saillies de cette partie de noyau en forme de E (27), une plaque en ferrite (28) est placée sur l'autre côté de la plaquette à circuit imprimé (15).
